# EUROPÄISCHE PATENTSCHRIFT

(11) **EP 1 874 977 B1**
(45) Veröffentlichungstag und Bekanntmachung des Hinweises auf die Patenterteilung: **22.07.2009**
(21) Anmeldenummer: 06742611.4
(22) Anmeldetag: 20.04.2006
(51) Int. Cl.: C23C 14/35, C23C 14/54

(54) **VERFAHREN UND VORRICHTUNG ZUM BESCHICHTEN VON SUBSTRATEN**
PROCESS AND DEVICE FOR COATING SUBSTRATES
PROCEDE ET DISPOSITIF POUR APPLIQUER UN REVETEMENT SUR DES SUBSTRATS

(30) Priorität: 25.04.2005 DE 102005019101
(43) Veröffentlichungstag der Anmeldung: 09.01.2008
(73) Patentinhaber: HamaTech AG, 75447 Sternenfels (DE)
(72) Erfinder: WEINDEL, Christian, 75433 Maulbronn (DE); LUKHAUB, Waldemar, 71665 Vaihingen (DE); PACEARESCU, Larisa c/o HamaTech AG, 75447 Sternenfels (DE); RUDAKOWSKI, Siegmar, 40885 Ratingen (DE)
(74) Vertreter: Wagner & Geyer
(86) Internationale Anmeldenummer: PCT/EP2006/003593
(87) Internationale Veröffentlichungsnummer: WO 2006/114228

(56) Entgegenhaltungen:
- WO-A-99/27758
- WO-A-20/05121392
- WO-A2-20/06019981
- JP-A- 10 130 833

## Beschreibung

Die vorliegende Erfindung bezieht sich auf ein Verfahren und eine Vorrichtung zum Beschichten von Substraten, bei dem das Substrat durch einen Magnetron-Zerstäubungsprozess mit einem rotierenden Magnetsystem beschichtet wird.

Zerstäubungsprozesse werden in unterschiedlichen Gebieten eingesetzt, um unterschiedliche Substrate zu beschichten, wobei die vorliegende Erfindung insbesondere die Beschichtung optischer Speichermedien in Betracht zieht. Bei der Herstellung optischer Speichermedien ist es besonders wichtig, dass die durch Zerstäubung bzw. Sputtern aufgebrachten Schichten keine großen Variationen hinsichtlich der Dicke aufweisen, da dies die Qualität der optischen Speichermedien wesentlich beeinträchtigen kann. Dies gilt einerseits für die Schichtdicke auf einem einzelnen Substrat, die möglichst homogen sein soll und andererseits auch für die Schichtdicke unterschiedlicher Substrate. Darüber hinaus besteht das Bedürfnis, dass die in den Zerstäubungskathoden verwendeten Targets möglichst viele Substrate beschichten, da die Targets mit hohen Kosten verbunden sind.

In der Vergangenheit wurden zur Optimierung von Sputterprozessen hinsichtlich einer Gleichmäßigkeit der aufgebrachten Schichtdicke, sowie einer Optimierung der Beschichtungen mit einem Target, unterschiedlichste Magnetsysteme entwickelt, die den Sputterprozess beeinflussen. Beispielsweise sind feststehende Magnetsysteme mit Permanentmagneten und/oder Elektromagneten, sowie rotierende Magnetsysteme bekannt. Bei den rotierenden Magnetsystemen wird eine bezüglich der Drehachse asymmetrische Magnetanordnung gedreht, um das Magnetfeld über die Sputteroberfläche des Targets zu streichen, um eine gleichmäßige Beschichtung des Substrats zu bewirken, sowie ein bestimmtes Abnutzungsprofil des Targets vorzusehen.

Das Dokument WO 99/27758 offenbart ein Verfahren und Vorrichtung zum Beschichten von Substraten, bei dem das Substrat durch einen Magnetron-Zerstäubungsprozess mit einem zu zerstäubenden Target und einem rotierenden Magnetsystem beschichtet wird. Ein Zustand des Verfahrens wird ermittelt, und die Rotationsgeschwindigkeit des Magnetsystems wird in Abhängigkeit von dem ermittelten Zustand gesteuert.

Während der Drehung des Magnetsystems werden jedoch durch das sich bewegenden Magnetfeld in dem Target und angrenzenden elektrisch leitenden Elementen Wirbelströme erzeugt, die wiederum das Magnetfeld beeinflussen. Dabei ist diese Veränderung des Magnetfelds abhängig von der Abnutzungsrate des Targets, so daß sich nach einer Vielzahl von Beschichtungsvorgängen Änderungen hinsichtlich einer homogenen Schichtdicke auf einem beschichteten Substrat bzw. dem Abnutzungsprofil des Targets ergeben können. Dies kann zu einer Verschlechterung der Substrate und einer Verkürzung der Targetlebenszeit führen.

Bei den Vorrichtungen zum Beschichten von Substraten, bei denen das Substrat durch einen Magnetron-Zerstäubungsprozess mit einem rotierenden Magnetsystem beschichtet wird, ist es ferner notwendig, zu detektieren, ob sich ein Zerstäubungstarget in der Vorrichtung befindet und ferner, ob der Antriebsmechanismus einwandfrei funktioniert. Hierzu wurden in der Vergangenheit dedizierte Sensoren eingesetzt.

Der vorliegenden Erfindung liegt daher die Aufgabe zugrunde, ein verfahren und Vorrichtung zum Beschichten von Substraten vorzusehen, das eine gleichmäßige Schichtdickenbildung auf Substraten und eine Optimierung der Lebenszeit eines zu zerstäubenden Targets erlaubt.

Erfindungsgemäß wird diese Aufgabe bei einem Verfahren zum Beschichten von Substraten, bei dem das Substrat durch einen Magnetron-Zerstäubungsprozess mit einem zu zerstäubenden Target und einem rotierenden Magnetsystem beschichtet wird, dadurch gelöst, dass die Rotationsgeschwindigkeit des Magnetsystems in Abhängigkeit von einem Zerstäubungszustand des Targets gesteuert wird. Durch die Steuerung der Rotationsgeschwindigkeit lassen sich die durch die Drehung des Magnetsystems induzierten Wirbelströme beeinflussen, wodurch sich das die Zerstäubung beeinflussende Magnetfeld hinsichtlich einer gleichmäßigen Beschichtung und einer Optimierung des Abnutzungsprofils des Targets einstellen läßt. Somit kann eine gleichmäßige Beschichtung der Substrate bei hoher Lebenszeit des Targets erreicht werden.

Vorzugsweise wird der Zerstäubungszustand des Targets anhand der verbleibenden Restlebenszeit ermittelt, die wiederum vorzugsweise durch Abziehen der Einsatzlebenszeit von einer Anfangslebenszeit ermittelt wird.

Gemäß einer Ausführungsform der Erfindung wird die Rotationsgeschwindigkeit des Magnetsystems mit zunehmender Zerstäubung des Targets, das heißt mit abnehmender Restlebenszeit verringert.

Das Verfahren ist besonders für die Beschichtung optischer Speichermedien mit einer Reflektionsschicht vorgesehen, wobei die Reflektionsschicht vorzugsweise aus einer Aluminium- oder Silberschicht oder Legierungen davon gebildet wird.

Die der Erfindung zugrundeliegende Aufgabe wird auch durch eine Vorrichtung zum Beschichten von Substraten gelöst, die eine Zerstäubungskathode mit einem Target und einem rotierenden Magnetsystem aufweist, wobei die Vorrichtung ferner Mittel zum Ermitteln eines Zerstäubungszustands des Targets sowie zum Steuern einer Rotationsgeschwindigkeit des Magnetsystems in Abhängigkeit vom ermittelten Zerstäubungszustand aufweist. Durch eine solche Vorrichtung lassen sich die schon oben genannten Vorteile hinsichtlich einer gleichmäßigen Beschichtung von Substraten und einer Optimierung des Abnutzungsprofils des Targets erreichen.

Gemäß einem bevorzugten Ausführungsbeispiel der Erfindung weist das Magnetsystem eine Jochplatte und wenigstens eine erste und eine zweite Gruppe von Magneten auf, die mit entgegengesetzter Polung auf der Jochplatte angeordnet sind, wobei die Magnete der ersten Gruppe eine im Wesentlichen geschlossene innenliegende Magnetreihe bilden und die Magnete der zweiten Gruppe eine im Wesentlichen geschlossene außenliegende Magnetreihe bilden, die die innenliegende Magnetreihe radial umgibt, wobei die innenliegende Magnetreihe einen ersten Kreisbogen bildet, der einen Winkel von größer 180° eines ersten Kreises beschreibt, sowie einen zweiten Kreisbogen eines zweiten Kreises, wobei der zweite Kreisbogen innerhalb des ersten Kreises liegt und wobei die außenliegende Magnetreihe einen dritten Kreisbogen bildet, der einen Winkel von größer 180° eines dritten Kreises beschreibt, sowie einen vierten Kreisbogen eines vierten Kreises, wobei der vierte Kreisbogen innerhalb des dritten Kreises liegt. Ein solches Magnetsystem besitzt einen einfachen Aufbau und fördert eine gleichmäßige Beschichtung der zu beschichtenden Substrate sowie eine hohe Targetausbeute, d.h. eine hohe Anzahl von Beschichtungsvorgängen pro Target.

Die Erfindung wird nachfolgend anhand eines bevorzugten Ausführungsbeispiels unter Bezugnahme auf die Zeichnungen näher erläutert; in den Zeichnungen zeigt:
- Fig.1: eine schematische Schnittansicht durch eine Zerstäubungskathode mit einem Magnetsystem gemäß der vorliegenden Erfindung;
- Fig. 2: eine schematische Draufsicht auf ein Magnetsystem gemäß der vorliegenden Erfindung; und
- Fig. 3: eine perspektivische auseinandergezogene Ansicht eines Magnetsystems gemäß der vorliegenden Erfindung;
- Fig. 4.: eine Tabelle, die unterschiedliche Drehgeschwindigkeiten eines Magnetsystems in Abhängigkeit von einer verbleibenden Targetlebenszeit zeigt.

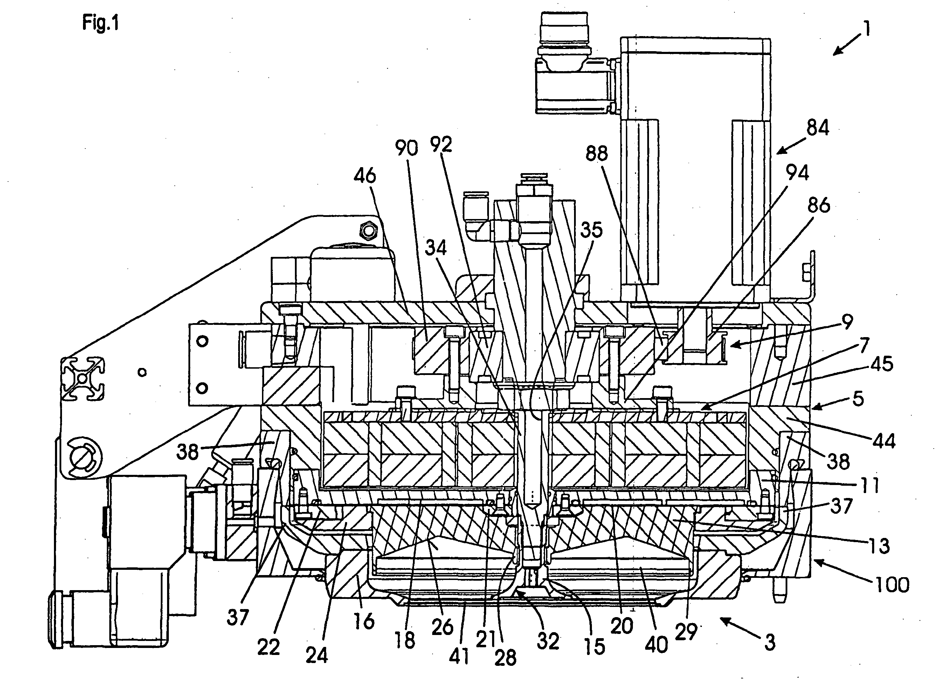

Fig. 1 zeigt eine Zerstäubungskathode 1, wie sie beispielsweise für die Beschichtung optischer Speichermedien eingesetzt wird.

Die Zerstäubungskathode 1 besitzt einen Zerstäubungsabschnitt 3, ein Gehäuse 5, ein in dem Gehäuse 5 aufgenommenes Magnetsystem 7 und eine Antriebsanordnung 9 für das Magnetsystem 7.

Der Zerstäubungsabschnitt 3 wird im Wesentlichen gebildet durch eine Kathodenplatte 11, die auch Teil des Gehäuses 5 ist, ein Target 13, sowie eine Innenmaske 15 und eine Außenmaske 16. Die Kathodenplatte 11, die beispielsweise aus Kupfer oder einer Kupferlegierung besteht, besitzt an ihrer nach unten weisenden Seite einen Kühlkanal 18, der mit einer nicht näher dargestellten Kühlmittelversorgung in Verbindung steht, um die Kathodenplatte bzw. das damit in Verbindung stehende Target 13 zu kühlen. Der Kühlkanal 18 ist durch eine, eine Mittelöffnung aufweisende Membran 20 abgedeckt, die über entsprechende Halteringe 21, 22 am Innenumfang bzw. am Außenumfang der Membran 20 an die Kathodenplatte 11 geklemmt ist. Um den Kühlkanal 18 abzudichten, sind zwischen der Membran 20 und der Kathodenplatte 11 im Bereich der Halteringe 21, 22 entsprechende Dichtelemente wie beispielsweise O-Ringe vorgesehen. Die Halteringe 21, 22 sind über Schrauben oder sonstige Befestigungselemente an der Kathodenplatte 11 befestigt.

Das Target 13 ist ebenfalls an der Kathodenplatte 11 befestigt und steht über die Membran 20 in elektrisch leitendem Kontakt hiermit. Das Target wird über einen Targethaltering 24 lösbar an der Kathodenplatte 11 gehalten. Der Targethaltering 24 steht mit dem äußeren Haltering 22 für die Membran 20 in Eingriff und stellt hierüber die Verbindung zur Kathodenplatte 11 her. Beispielsweise steht der Targethaltering 24 mit dem Haltering 22 in Schraubkontakt. Die Membran 20, die Halteringe 21, 22 sowie der Targethaltering 24 sind jeweils aus einem elektrisch leitenden Material hergestellt, und stellen eine elektrische Verbindung zwischen der Kathodenplatte 11 und dem Target 13 sicher.

Das Target 13 besitzt eine kreiszylindrische Form mit einer im Wesentlichen ebenen Rückseite, in der eine Ausnehmung zur Aufnahme des Halterings 21 vorgesehen ist. Ferner besitzt das Target 13 eine Mittelöffnung zur Durchführung der Innenmaske 15, wie nachfolgend noch näher erläutert wird.

Das Target 13 besitzt eine ringförmige Zerstäubungsoberfläche 26, die durch zwei zur Rückseite geneigte, sich schneidende Geraden gebildet wird. Der Innenumfang der Zerstäubungsoberfläche 26 wird durch einen ringförmigen Vorsprung 28 begrenzt, während der Außenumfang der ringförmigen Zerstäubungsoberfläche 26 durch einen ringförmigen Vorsprung 29 begrenzt wird.

Wie zuvor angedeutet, erstreckt sich die Innenmaske 15 durch eine Mittelöffnung des Targets 13 hindurch. Vor dem Target besitzt die Innenmaske 15 einen sich erweiternden Kopfteil 32, der dazu dient, einen Mittelbereich eines zu beschichtenden Gegenstands gegenüber der Zerstäubungsoberfläche 26 abzuschirmen. Die Innenmaske 15 ist gegenüber der Kathodenplatte 11 und dem Target 13 elektrisch isoliert, und wird durch einen sogenannten Kühlfinger 34 getragen. Der Kühlfinger 34 erstreckt sich in die Mittelöffnung des Targets 13, durch die Kathodenplatte 11, das Magnetsystem 7 und ist am Gehäuse 5 befestigt. Zwischen dem Kühlfinger 34 und der Kathodenplatte 11 ist ein Isolierelement vorgesehen, um den Kühlfinger 34 gegenüber der Kathodenplatte 11 elektrisch zu isolieren.

Der Kühlfinger 34 weist eine Sackbohrung 35 auf, in die in geeigneter Weise eine Kühlflüssigkeit ein- und auch wieder ausgeleitet wird, um die Innenmaske 15 zu kühlen.

Hierzu sind entsprechende Anschlusselemente an dem Kühlfinger 34 vorgesehen.

Die Außenmaske 16 steht über entsprechende Halteringe 37, 38 mit dem Gehäuse 5 in Kontakt und wird hierdurch gegen eine Deckelplatte einer Sputterkammer gedrückt. Die Außenmaske 16 sowie die sie tragenden Elemente sind gegenüber der Kathodenplatte 11 elektrisch isoliert. Das Target 13, die Maske 15 und die Außenmaske 16 definieren einen Zerstäubungsraum 40 mit einer ringförmigen Öffnung 41, die während eines Beschichtungsvorgangs durch ein zu beschichtendes Substrat im Wesentlichen geschlossen wird.

Das Gehäuse 5 der Zerstäubungskathode 1 besteht, wie schon erwähnt, unter anderem aus der Kathodenplatte 11. An die Kathodenplatte 11 schließt sich ein elektrisch isolierendes ringförmiges Gehäusebauteil 44 an. An das ringförmige, isolierende Gehäusebauteil 44 schließt sich ein weiteres ringförmiges Gehäusebauteil 45 an, das wiederum mit einer Rückplatte 46 des Gehäuses 5 verbunden ist. Die Kathodenplatte 11, die Gehäusebauteile 44, 45 sowie die Rückplatte 46 bilden zusammen ein im Wesentlichen geschlossenes Gehäuse zur Aufnahme und zum Halten des Magnetsystems 7, des Kühlfingers 34 für die Innenmaske 15, und der Antriebsanordnung 9 für das Magnetsystem, wie nachfolgend noch näher erläutert wird.

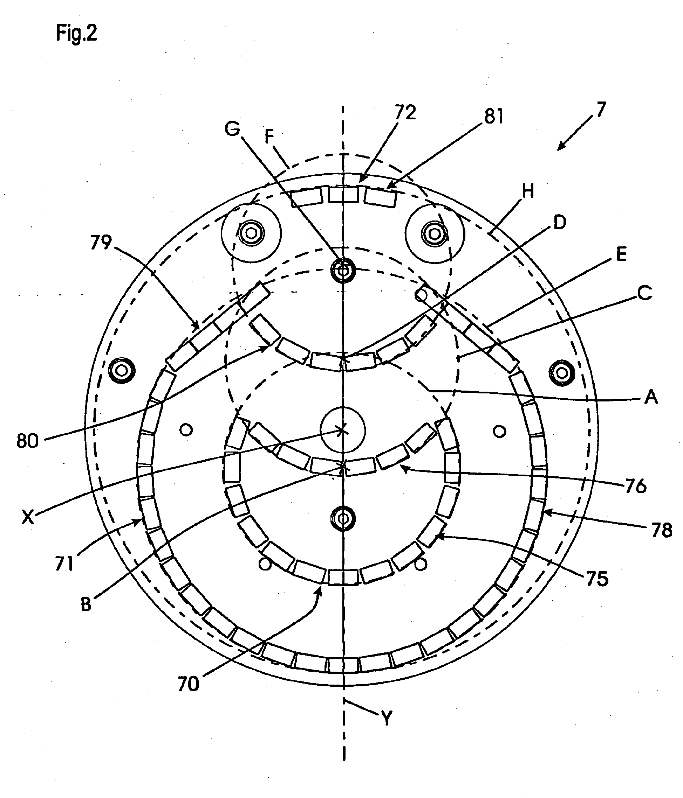

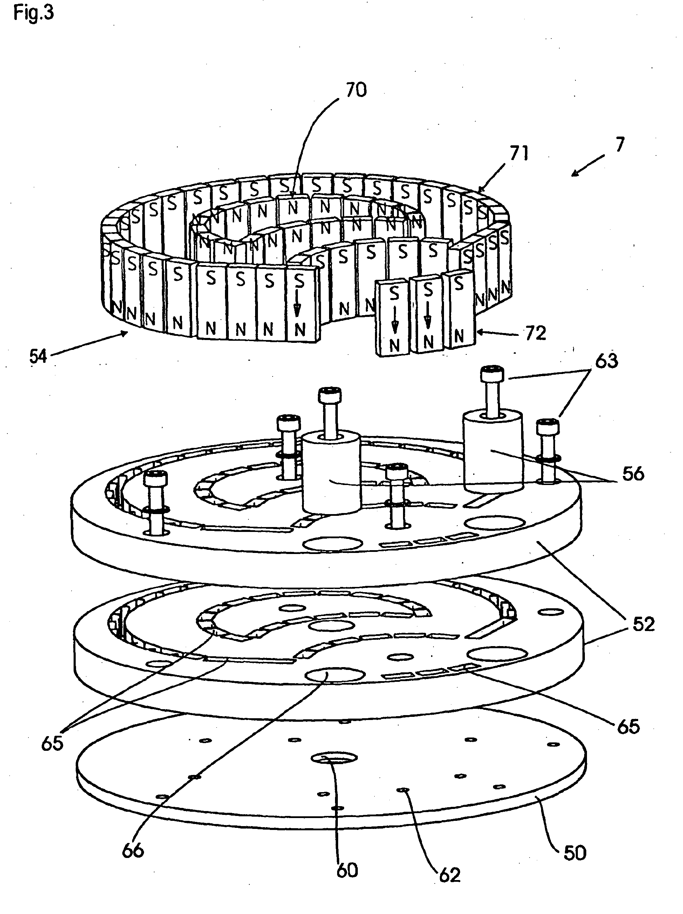

Das Magnetsystem 7 wird nachfolgend unter Bezugnahme auf die Figuren, insbesondere die Figuren 2 und 3 näher erläutert. Dabei zeigt Fig. 2 eine Draufsicht auf das Magnetsystem 7 und Fig. 3 eine perspektivische, auseinandergezogene Ansicht des Magnetsystems 7.

Das Magnetsystem 7 besteht, wie am Besten in Fig. 3 zu erkennen ist, aus einer Jochplatte 50, zwei Führungsplatten 52, einer Vielzahl von quaderförmigen Magneten 54, sowie Ausgleichsgewichten 56.

Die Jochplatte 50 besteht aus einem magnetisch leitenden Material und besitzt die Form einer flachen, runden Scheibe mit einer kreisförmigen Mittelöffnung 60. Die Mittelöffnung 60 ist derart bemessen, dass sie eine kontaktfreie Durchführung des Kühlfingers 34 für die Mittelmaske 15 ermöglicht.

Die Jochplatte 50 weist ferner eine Vielzahl von Bohrungen 62 zur Aufnahme von Befestigungselementen, wie beispielsweise Schrauben 63 auf, die beispielsweise zur Befestigung der Führungsplatten 52 bzw. der Ausgleichsgewichte 56 dienen.

Die Führungsplatten 52 sind jeweils aus einem unmagnetischen, nicht leitenden Material, wie beispielsweise Kunststoff. Die Führungsplatten 52 besitzen im Wesentlichen dieselbe Form und dienen vorwiegend zur formschlüssigen Aufnahme der Magnete 54. Zu diesem Zweck weisen die Führungsplatten 52 entsprechende Durchgangsöffnungen 65 zur Aufnahme der Magnete 54 auf. Die Durchgangsöffnungen 65 erstrecken sich jeweils senkrecht zu einer Ebene der Führungsplatten 52. Die Anordnung der Durchgangsöffnungen 65 bestimmt die Anordnung der Magneten 54, die nachfolgend noch näher beschrieben wird.

Die Führungsplatten 52 weisen ferner Durchgangsöffnungen 66 zur Aufnahme der Ausgleichsgewichte 56 auf, und sind über entsprechende Befestigungselemente, wie beispielsweise Schrauben 63, an der Jochplatte 50 befestigt.

Im Nachfolgenden wird die Anordnung der Vielzahl von Magneten 54 näher erläutert.

Die Magnete 54 sind in drei Gruppen unterteilt; eine erste Gruppe 70, eine zweite Gruppe 71 und eine dritte Gruppe 72. Die Magnete der ersten Gruppe 70 sind mit entgegengesetzter Polung zu den Magneten der zweiten Gruppe 71 auf der Jochplatte 50 angeordnet, wie in Fig. 3 zu erkennen ist. Die Magnete der zweiten Gruppe sind mit der gleichen Polung auf der Jochplatte 50 angeordnet, wie die Magneten der dritten Gruppe 72, wie ebenfalls in Fig. 3 zu erkennen ist.

Wie in der Draufsicht gemäß Fig. 2 zu erkennen ist, bilden die Magnete der ersten Gruppe 70 eine im Wesentlichen geschlossene innenliegende Magnetreihe, während die Magnete der zweiten Gruppe 71 eine im Wesentlichen geschlossene außenliegende Magnetreihe bilden. Die Magnete der dritten Gruppe 72 bilden hingegen keine geschlossene Magnetreihe und liegen außerhalb der ersten und zweiten geschlossenen Magnetreihe.

Ein Teil der Magnete der ersten Gruppe 70 beschreibt einen ersten Kreisbogen 75 eines ersten Kreises A. Dabei liegen die den Kreisbogen 75 beschreibenden Magnete mit ihrer Außenseite an dem Kreis A an. Der Kreisbogen 75 besitzt einen Winkel von größer 180°, und insbesondere einen Winkel zwischen 220° und 250°, vorzugsweise von ungefähr 235°. Ein Mittelpunkt B des Kreises A ist bezüglich eines Mittelpunktes X der Jochplatte 50 entlang einer Geraden Y versetzt. Wie nachfolgend noch näher beschrieben wird, ist das Magnetsystem 7 bezüglich der Geraden Y spiegelsymmetrisch.

Ein zweiter Teil der ersten Gruppe 70 von Magneten bildet einen zweiten Kreisbogen 76 eines zweiten Kreises C. Der zweite Kreisbogen 76 beschreibt einen Winkel zwischen 90° und 120° und vorzugsweise von ungefähr 103°. Der zweite Kreisbogen 76 liegt innerhalb des Kreises A und verbindet die freien Enden des ersten Kreisbogens 75, um eine geschlossene Magnetreihe zu bilden. Dabei besitzt die geschlossene Magnetreihe eine Mondform.

Ein Mittelpunkt D des Kreises C liegt ebenfalls auf der Geraden Y und zwar versetzt zum Mittelpunkt X der Jochplatte 50. Die Mittelpunkte der ersten und zweiten Kreise A, C liegen entlang der Linie Y auf entgegengesetzten Seiten des Mittelpunktes X der Jochplatte 50.

Ein Teil der Magnete der zweiten Gruppe 71 der Vielzahl von Magneten 54 bildet einen dritten Kreisbogen 78 eines dritten Kreises E. Der Mittelpunkt des Kreises E fällt mit dem Mittelpunkt B des ersten Kreises A zusammen, so dass die ersten und dritten Kreisbögen 75, 78 koaxial zueinander sind.

Der dritte Kreisbogen 78 beschreibt wiederum einen Winkel von größer 180°. Dabei beschreibt der dritte Kreisbogen einen Winkel zwischen 225° und 255° und vorzugsweise von ungefähr 239°.

Ein Teil der zweiten Gruppe 71 der Vielzahl von Magneten 54 bildet zwei gerade Abschnitte 79 der geschlossenen Magnetreihe. Die geraden Abschnitte 79 erstrecken sich im Wesentlichen von den freien Enden des dritten Kreisbogens 78 aus und sind zur Geraden Y hin geneigt. Die geraden Abschnitte 79 liegen im Wesentlichen im Inneren des Kreises E und bilden eine Kreissehne desselben. Die beiden geraden Abschnitte 79 sind ungefähr mit einem Winkel von 100° zueinander angeordnet.

Ein weiterer Teil der Magneten der zweiten Gruppe 71 der Vielzahl von Magneten 54 bildet einen vierten Kreisbogen 80 eines vierten Kreises F. Ein Mittelpunkt G des Kreises F liegt wiederum auf der Geraden Y und ist bezüglich des Mittelpunkts X der Jochplatte 50 versetzt. Der Mittelpunkt G des Kreises F und der Mittepunkt B des Kreises E liegen entlang der Linie Y auf entgegengesetzten Seiten des Mittelpunkts X der Jochplatte 50. Der Mittelpunkt G des Kreises F ist weiter vom Mittelpunkt X der Jochplatte 50 entfernt als der Mittelpunkt D des Kreises C. Der Mittelpunkt B der Kreise A und E befindet sich wiederum näher an dem Mittelpunkt X der Jochplatte 50 als der Mittelpunkt D.

Der Kreisbogen 80 verbindet im Wesentlichen die freien Enden der geraden Abschnitte 79. Somit bilden die Magnete, die den dritten Kreisbogen 78, die geraden Abschnitte 79 und den vierten Kreisbogen 80 bilden, eine im Wesentlichen geschlossene äußere Magnetreihe.

Der vierte Kreisbogen beschreibt einen Winkel zwischen 90° und 125° und vorzugsweise von ungefähr 111°.

Der Radius des dritten Kreises E ist wesentliche größer als der Radius des vierten Kreises F. Vorzugsweise ist der Radius des dritten Kreises E um 80 bis 100 %, vorzugsweise um ungefähr 90 % größer als der Radius des vierten Kreises F. Ferner ist der Radius des dritten Kreises E auch größer als der jeweilige Radius des Kreises A bzw. des Kreises C. Die Radien der Kreise A und C sind im Wesentlichen gleich.

Die Magnete der dritten Gruppe 72 der Vielzahl von Magneten 54 bilden, wie erwähnt, eine nicht geschlossene Magnetreihe und beschreiben einen fünften Kreisbogen 81 eines fünften Kreises H, dessen Mittelpunkt mit dem Mittelpunkt X der Jochplatte 50 zusammenfällt. Der Kreis H besitzt den größten Radius und die Magnete der ersten und zweiten Gruppe liegen innerhalb des Kreises H. Der fünfte Kreisbogen beschreibt einen Winkel von 15° bis 45° und vorzugsweise von ungefähr 32°. Die Führungsplatten 52 weisen entsprechende Durchgangsöffnungen 65, um die Magneten 54 in der oben genannten Art und Weise anzuordnen.

Die Ausgleichsgewichte 56 bestehen aus einem nicht magnetischen Material und liegen im Wesentlichen innerhalb des Kreises H. Sie dienen dazu, sicherzustellen, dass ein Schwerpunkt des Magnetsystems 7, bestehend aus Jochplatte 50, Führungsplatten 52, Magneten 54 und Ausgleichsgewichten 56 entlang einer sich senkrecht zu einer Ebene der Jochplatte 50 und durch den Mittelpunkt X erstreckenden Achse liegt. Diese Achse ist, wie nachfolgend noch näher beschrieben wird, eine Drehachse des Magnetsystems 7. Die Ausgleichsgewichte 56 sind über entsprechende Befestigungselemente, wie beispielsweise Schrauben 63 an der Jochplatte 50 befestigt.

Bei der oben dargestellten Anordnung der Magneten 54 wird zwischen der ersten Gruppe 70 und der zweiten Gruppe 71 von Magneten ein Magnetfeldtunnel gebildet, der sich durch das Target 13 hindurch erstreckt. Dieser Magnetfeldtunnel besitzt einen Scheitelpunkt, der im Wesentlichen auf einer zwischen der ersten Gruppe 70 und der zweiten Gruppe 71 von Magneten liegenden Linie liegt, und somit bezüglich der Mitte der Jochplatte asymmetrisch ist.

Die dritte Gruppe von Magneten 72 besitzt den Zweck zu verhindern, dass sich ein zusätzlicher Magnettunnel bildet, der sich ausgehend von den Magneten des Kreisbogens 80 nach außen erstreckt. Dadurch, dass die Magnete der zweiten Gruppe 71 und der dritten Gruppe 72 in gleicher Richtung gepolt sind, wirken hier abstoßende Magnetkräfte, die die Bildung eines Magnetfeldtunnels unterdrücken.

Nachfolgend wird die Antriebsanordnung 9 der Zerstäubungskathode 1 näher erläutert. Die Antriebsanordnung 9 weist einen Antriebsmotor 84 auf, der an der Rückplatte 46 des Gehäuses 5 angebracht ist, und zwar im Wesentlichen außerhalb des Gehäuses 5. Eine Drehwelle 86 des Antriebsmotors 84 erstreckt sich durch eine entsprechende Öffnung in der Rückplatte 46 des Gehäuses 5 in das Gehäuse 5 hinein. Ein freies Ende der Drehwelle 86 steht über einen Keilriemen 88 mit einem Ringelement 90 in Verbindung, um eine Drehbewegung der Drehwelle 86 auf das Ringelement 90 zu übertragen. Das Ringelement 90 ist über eine entsprechende Lageranordnung 92 an den Kühlfinger 34 getragen. Dabei ist das Ringelement derart an dem Kühlfinger 34 getragen, dass es in Längsrichtung des Kühlfingers 34 nicht bewegbar ist, sich jedoch um den Kühlfinger 34 herum drehen kann. Das Ringelement 90 ist somit örtlich stationär, aber drehbar innerhalb des Gehäuses 5 getragen.

Das Ringelement 90 ist mit einem Tragflansch 94 für die Jochplatte 50 verbunden, und zwar über entsprechende Befestigungselemente, wie beispielsweise Schrauben. Der Tragflansch 94 steht darüber hinaus auch mit der Lageranordnung 92 in Verbindung und ist durch diese geführt.

Der Tragflansch 94 ist wiederum über entsprechende Befestigungselemente, wie beispielsweise Schrauben mit einer von den Magneten 54 abgewandten Seite der Jochplatte 50 verbunden, wie in Fig. 1 zu erkennen ist.

Die Antriebsanordnung 9 der Zerstäubungskathode 1 weist ferner eine nicht näher dargestellte Steuereinheit zum Steuern des Antriebsmotors 84 auf. Die Steuereinheit ist in der Lage den Antriebsmotor mit unterschiedlichen Drehgeschwindigkeiten anzusteuern. Unterschiedliche Drehgeschwindigkeiten können für unterschiedliche Targetmaterialien eingesetzt werden. Darüber hinaus ist die Steuereinheit in der Lage die Drehgeschwindigkeit des Magnetsystems in Abhängigkeit von einem Zerstäubungszustand des Targets zu steuern. Hierzu ermittelt die Steuereinheit zunächst den Zerstäubungszustand des Targets und stellt in Abhängigkeit davon die Drehgeschwindigkeit des Antriebsmotors 84 und somit die Drehgeschwindigkeit des Magnetsystems 7 ein. Bei dem Antriebsmotor handelt es sich insbesondere um einen Servomotor mit Regler. Falls das Magnetsystem wegen eines mechanischen Defekts blockiert, kann dies über den Regler, der die Umdrehungszahl und die Position der Drehachse ausgeben kann, festgestellt werden. Falls zum Beispiel der Antriebsriemen, der die Drehachse des Magnetsystems mit der Antriebswelle des Motors verbindet reißt, dreht der Motor zwar mit der vorgegebenen Umdrehungszahl, doch über das geringere Drehmoment und die dann reduzierte Stromaufnahme des Motors kann festgestellt werden, dass die Verbindung zum Magnetsystem unterbrochen ist. Ferner kann über den Servomotor mit Regler festgestellt werden, falls sich kein Target 13 in der Zerstäubungskathode befindet, da sich bei fehlendem Target die induzierten Wirbelstürme und somit auch das Drehmoment reduzieren. Dies kann der Regler über die Stromaufnahme feststellen, so dass hierüber festgestellt werden kann, ob sich ein Target in der Vorrichtung befindet.

Nachfolgend wird der Betrieb der Zerstäubungskathode 1 anhand der Figuren näher erläutert.

Die Zerstäubungskathode 1 sitzt auf einem Gehäuse einer Vakuumkammer auf, das bei 100 angedeutet ist, und erstreckt sich teilweise in das Vakuumgehäuse hinein. Über eine nicht näher dargestellte Handhabungsvorrichtung wird ein zu beschichtendes Substrat; wie beispielsweise ein Substrat eines optischen Datenträger in den Bereich der ringförmigen Öffnung 41 des Zerstäubungsraums 40 gebracht, und in Kontakt mit der Innen- und Außenmaske 15 bzw. 16 gebracht, um den Zerstäubungsraum 40 im Wesentlichen abzuschließen.

Anschließend wird eine negative Spannung von ungefähr -800 Volt an die Kathodenplatte 11 und somit das Target 13 angelegt. Die Innen- und Außenmaske sind in geeigneter Weise geerdet und wirken daher als Anode.

Über nicht näher dargestellte Zuleitungen wird Argongas in den Prozessraum 40 eingeführt, wo es in bekannter Weise ionisiert und in Richtung der Zerstäubungsoberfläche 26 des Targets 13 beschleunigt wird. Die Argonionen werden durch den sich durch das Target 13 hindurch erstreckenden Magnetfeldtunnel konzentriert, wodurch die Zerstäubung der Zerstäubungsoberfläche 26 gesteuert werden kann. Durch eine derartige Steuerung der Zerstäubung lässt sich andererseits die durch Zerstäubung aufgebrachte Schichtdicke steuern, als auch eine bestimmte Abnutzung des Targets 13 erreichen, so dass dieses für möglichst viele Zerstäubungsvorgänge eingesetzt werden kann. Während des Zerstäubungsvorgangs wird das Magnetsystem 7 um eine Drehachse gedreht, so dass der bezüglich der Drehachse asymmetrische Magnetfeldtunnel über das Target 13 streicht.

der Drehung des Magnetsystems 7 werden durch den sich bewegenden Bei der Drehung des Magnetsystems 7 werden durch den sich bewegenden Magnetfeldtunnel in dem Target 13 und sonstigen elektrisch leitenden Teilen Wirbelströme erzeugt, die wiederum das Magnetfeld verändern. Dabei ist diese Veränderung des Magnetfelds wie erwähnt abhängig von der Abnutzungsrate des Targets 13. Um jedoch über eine Vielzahl von Beschichtungsvorgängen hinweg im Wesentlichen gleiche Bedingungen hinsichtlich des Magnetfelds zu erreichen, wird die Drehgeschwindigkeit des Magnetsystems 7 in Abhängigkeit von einer Abnutzungsrate des Targets 13 gesteuert. Insbesondere wird mit zunehmendem Targetalter (d.h. steigende Anzahl von Sputtervorgängen) die Drehzahl für das Magnetsystem reduziert.

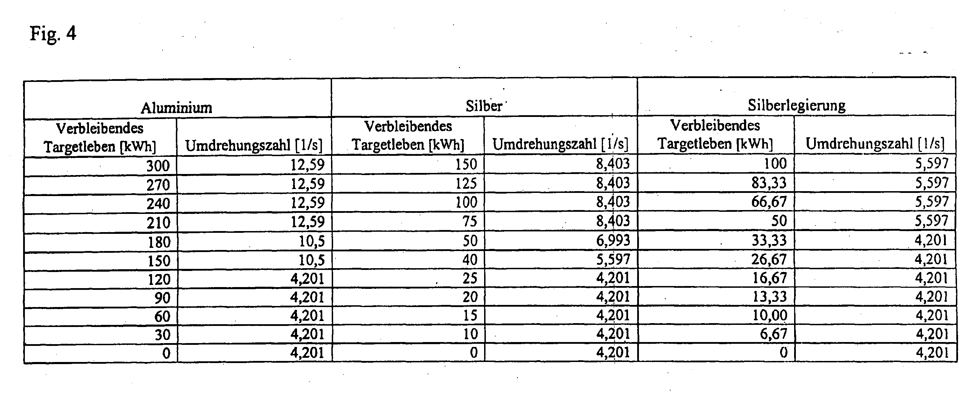

Fig. 4 zeigt in Tabellenform unterschiedliche Umdrehungszahlen in Abhängigkeit von einer verbleibenden Targetlebenszeit, die in Kilowatt-Stunden ausgedrückt ist. Dabei zeigt die Tabelle unterschiedliche Umdrehungszahlen für Targets aus Aluminium, Silber und einer Silberlegierung.

Wie deutlich zu erkennen ist, kann die Drehzahl während eines ersten Teilbereichs der Targetlebenszeit zunächst konstant gehalten werden, wobei sie anschließend reduziert wird.

Bei Aluminium wird die Drehzahl beispielsweise gegen Ende der verbleibenden Lebenszeit auf ungefähr 1/3 der ursprünglichen Drehzahl reduziert. Bei einem Silbertarget wird die Drehzahl auf ungefähr die Hälfte der ursprünglichen Drehzahl reduziert und bei einer Silberlegierung auf ca. 3/4 der ursprünglichen Drehzahl.

Welche Drehzahlwerte bei welcher verbleibenden Targetlebenszeit vorteilhaft sind, kann empirisch ermittelt werden und in einer entsprechenden Nachschautabelle, die für jedes Targetmaterial gespeichert werden kann, hinterlegt werden.

Die Steuervorrichtung für den Antriebsmotor kann auf die Nachschautabelle zugreifen und die Drehzahl entsprechend steuern. Natürlich ist es auch möglich die Abnutzungsrate des Targets auf andere Art und Weise zu ermitteln. Beispielsweise kann die Anzahl der durchgeführten Sputtervorgänge mit der Abnutzung des Targets in Verbindung gesetzt werden. Alternativ könnte auch ein Sensor eingesetzt werden, der die Targetoberfläche und somit die Abnutzungsrate scannt. Ein solcher Sensor könnte dann auch eingesetzt werden, um festzustellen, ob sich überhaupt ein Target in der Vorrichtung befindet. Auf Grund der mit solchen Sensoren assoziierten Kosten werden jedoch Ermittlungsverfahren für die Abnutzung des Targets bevorzugt, die keine zusätzlichen Sensoren erfordern.

Die Erfindung wurde zuvor anhand eines bevorzugten Ausführungsbeispiels der Erfindung beschrieben, ohne auf das konkret dargestellte Ausführungsbeispiel beschränkt zu sein.

## Patentansprüche

1. Verfahren zum Beschichten von Substraten, bei dem das Substrat durch eine Magnetron-Zerstäubungsprozess mit einem zu zerstäubenden Target und einem rotierenden Magnetsystem beschichtet wird, **dadurch gekennzeichnet, dass** ein Zerstäubungszustand des Targets ermittelt wird, und die Rotationsgeschwindigkeit des Magnetsystems in Abhängigkeit von dem ermittelten Zerstäubungszustand des Targets gesteuert wird.

2. Verfahren nach Anspruch 1, **dadurch gekennzeichnet, dass** der Zerstäubungszustand des Targets anhand der verbleibenden Restlebenszeit und/oder anhand der Anzahl von durchgeführten Zerstäubungsvorgängen ermittelt wird.

3. Verfahren nach einem der vorhergehenden Ansprüche, **dadurch gekennzeichnet, dass** die Rotationsgeschwindigkeit des Magnetsystems mit zunehmender Zerstäubung des Targets verringert wird.

4. Verfahren nach einem der vorhergehenden Ansprüche, **dadurch gekennzeichnet; dass** ein optisches Speichermedium mit einer Reflexionsschicht beschichtet wird, wobei die Reflexionsschicht vorzugsweise aus einer Aluminium- oder Silberschicht oder Legierungen davon gebildet wird.

5. Verfahren nach einem der vorhergehenden Ansprüche, **dadurch gekennzeichnet, dass** die Rotationsgeschwindigkeit des Magnetsystems auch in Abhängigkeit vom verwendeten Targetmaterial gewählt wird.

6. Verfahren nach einem der vorhergehenden Ansprüche, **dadurch gekennzeichnet, dass** anhand einer Energieaufnahme eines Motors festgestellt wird, ob sich ein Target in der Zerstäubungsvorrichtung befindet und/oder ob sich das Magnetsystem ordnungsgemäß dreht.

7. Vorrichtung zum Beschichten von Substraten, die eine Zerstäubungskathode mit einem Target und einem rotierenden Magnetsystem aufweist, **dadurch gekennzeichnet, dass** Mittel zum Ermitteln eines Zerstäubungszustandes des Targets sowie zum Steuern einer Rotationsgeschwindigkeit des Magnetsystems in Abhängigkeit vom ermittelten Zerstäubungszustand vorgesehen sind.

8. Vorrichtung nach Anspruch 7, **dadurch gekennzeichnet, dass** das Magnetsystem folgendes aufweist, eine Jochplatte (50) und wenigstens eine erste Gruppe (70) und einer zweiten Gruppe (71) von Magneten, die mit entgegengesetzter Polung auf der Jochplatte (50) angeordnet sind, wobei die Magnete der ersten Gruppe (70) eine im Wesentlichen geschlossene innenliegende Magnetreihe bilden und die Magnete der zweiten Gruppe (71) eine im Wesentlichen geschlossene außenliegende Magnetreihe bilden, die die innenliegende Magnetreihe radial umgibt, wobei die innenliegende Magnetreihe einen ersten Kreisbögen (75) bildet, der einein Winkel von größer 180° eines ersten Kreises (4) beschreibt, sowie einen zweiten Kreisbogen (76) eines zweiten Kreises (C), wobei der zweite Kreisbogens (76) innerhalb des ersten Kreises (A) liegt und wobei die außenliegende Magnetreihe einen dritten Kreisbogen (78) bildet, der einen Winkel von größer 180° eines dritten Kreises (E) beschreibt, sowie einen vierten Kreisbogen. (80) eines vierten Kreises (F), wobei der vierte Kreisbogen (80) innerhalb des dritten Kreises (E) liegt, und der dritte Kreis (E) den ersten Kreis (A) umgibt, wobei die ersten und dritten Kreise (A, E) vorzugsweise einen gemeinsamen Mittelpunkt B aufweisen.

9. Vorrichtung nach Anspruch 8, **dadurch gekennzeichnet, dass** der erste Kreisbogen (75) einen Winkel zwischen 220° und 250°, und vorzugsweise von ungefähr 235° beschreibt, und/oder
der zweite Kreisbogen (76) einen Winkel zwischen 90° und 120°, und vorzugsweise von ungefähr 103° beschreibt, und/oder
die ersten und zweiten Kreise (A, C) der innenliegenden Magnetreihe im Wesentlichen den gleichen Radius aufweisen, und/oder
der dritte Kreisbogen (78) einen Winkel zwischen 225° und 255°, und vorzugsweise von ungefähr 239° beschreibt, und/oder
der vierte Kreisbogen (80) einen Winkel zwischen 95° und 125°, und vorzugsweise von ungefähr 111° beschreibt, und/oder
der Radius des dritten Kreise (E) größer ist als der Radius des vierten Kreises (F), wobei
der Radius des dritten Kreises (E) vorzugsweise um 80% bis 100%, insbesondere um ungefähr 90% größer ist als der Radius des vierten Kreises (F), und/oder
die außenliegende Magnetreihe zwei gerade Segmente (79) aufweist, die die freien Enden der dritten und vierten Kreisbögen (78, 80) verbinden.

10. Vorrichtung nach einem der Ansprüche 8 oder 9, **gekennzeichnet durch** eine dritte Gruppe (72) von Magneten, die auf der Jochplatte (50) angeordnet ist, eine dem vierten Kreisbogen (80) gegenüberliegende nicht geschlossene Magnetreihe bildet und außerhalb der ersten und zweiten geschlossenen Magnetreihen liegt, wobei
die dritte Gruppe (72) von Magneten vorzugsweise in der gleichen Richtung gepolt ist, wie die zweite Gruppe (71) von Magneten, und/oder
die dritte Gruppe (72) von Magneten einen fünften Kreisbogen (81) eines fünften Kreises (H) mit einem Winkel von 15° bis 45° und insbesondere von ungefähr 32° beschreibt, wobei
der fünfte Kreis (H) vorzugsweise einen größeren Radius besitzt als der dritte Kreis (E), und/oder
die dritte Gruppe (72) von Magneten innerhalb des vierten Kreises (F) liegt.

11. Vorrichtung nach einem der Ansprüche 8 bis 10, **dadurch gekennzeichnet, dass** die Mittelpunkte der Kreise auf einer gemeinsamen Geraden liegen, und/oder
die Magnetreihen zu der Geraden spiegelsymmetrisch sind, und/oder
die Jochplatte (50) eben ist, und um einen Mittelpunkt (X) rotationssymmetrisch ist, und/oder
ein Mittelpunkt (X) der Jochplatte und die Mittelpunkte (B, D, G) der Kreise (A, C, E, F, H) auf einer gemeinsamen Geraden (Y) liegen, wobei
der gemeinsame Mittelpunkt (B) des ersten und dritten Kreises (A, E) vorzugsweise entlang der Geraden (Y) zum Mittelpunkt (X) der Jochplatte versetzt ist, wobei
die Mittelpunkte (D, G) des zweiten und vierten Kreises (C, F) vorzugsweise entlang der Geraden (Y) zum Mittelpunkt der Jochplatte versetzt sind und vorzungsweise bezüglich des Mittelpunkts (X) der Jochplatte auf einer anderen Seite liegen, wie der gemeinsame Mittelpunkt (B) des ersten und dritten Kreises (A, E), wobei
der gemeinsame Mittelpunkt (B) des ersten und dritten Kreises (A, E) vorzungweise mit einem Abstand zum Mittelpunkt (X) der Jochplatte angeordnet ist, der kleiner ist als ein Abstand zwischen dem Mittelpunkt (X) der Jochplatte und dem Mittelpunkt (D) des zweiten Kreises (C), und der Mittelpunkt (G) des vierten Kreises (F) vorzugsweise mit einem größeren Abstand zum Mittelpunkt (X) der Jochplatte (50) angeordnet ist, als der Mittelpunkt (D) des Kreises (C), und/oder
die Magnete (54) durch wenigstens eine nichtmagnetische Platte (52) mit entsprechenden Durchführöffnungen für die Magnete (54) geführt sind, und/oder dass
unmagnetische Ausgleichsgewichte (56) an der Jochplatte (50) zum Ausgleichen des Gewichts des Magnetsystems (7) derart vorgesehen sind, dass deren Schwerpunkt auf einer sich durch einen Mittelpunkt (X) der Jochplatte (50) erstreckenden Normalen liegt.

## Claims

1. Method of coating substrates, in which the substrate is coated by a magnetron atomisation process with a target, which is to be atomised, and a rotating magnet system, **characterised in that** an atomisation state of the target is determined and the rotational speed of the magnetic system is controlled in dependence on the determined atomisation state of the target.

2. Method according to claim 1, **characterised in that** the atomisation state of the target is determined on the basis of the remaining residual service life and/or on the basis of the number of atomisation processes performed.

3. Method according to one of the preceding claims, **characterised in that** the rotational speed of the magnet system is reduced with increasing atomisation of the target.

4. Method according to any one of the preceding claims, **characterised in that** an optical storage medium is coated with a reflective layer, wherein the reflective layer is preferably formed from an aluminium or silver layer or alloys thereof.

5. Method according to any one of the preceding claims, **characterised in that** the rotational speed of the magnet system is also selected in dependence on the target material employed.

6. Method according to any one of the preceding claims, **characterised in that** it is determined on the basis of an energy consumption of a motor whether a target is disposed in the atomisation device and/or whether the magnet system rotates correctly.

7. Device for coating substrates, which comprises an atomisation cathode with a target and a rotating magnet system, **characterised in that** means for determining an atomisation state of the target and for controlling a rotational speed of the magnet system are provided in dependence on the determined atomisation state.

8. Device according to claim 7, **characterised in that** the magnet system comprises the following: a yoke plate (50) and at least one first group (70) and second group (71) of magnets, which are arranged with opposite poling on the yoke plate (50), wherein the magnets of the first group (70) form a substantially closed inwardly disposed magnet series and the magnets of the second group (71) form a substantially closed outwardly disposed magnet series which radially surrounds the inwardly disposed magnet series, wherein the inwardly disposed magnet series forms a first arc (75) describing an angle of more than 180° of a first circle (A) as well as a second arc (76) of a second circle (C), wherein the second arc (76) lies within the first circle (A) and wherein the outwardly disposed magnet series forms a third arc (78) which describes an angle of more than 180° of a third circle (E) as well as a fourth arc (80) of a fourth circle (F), wherein the fourth arc (80) lies within the third circle (E) and the third circle (E) surrounds the first circle (A), wherein the first and third circles (A, E) preferably have a common centre point B.

9. Device according to claim 8, **characterised in that** the first arc (75) describes an angle between 220° and 250°, preferably approximately 235°, and/or the second arc (76) describes an angle between 90° and 120°, preferably approximately 103°, and/or the first and second circles (A, C) of the inwardly disposed magnet series have substantially the same radius, and/or the third arc (78) describes an angle between 225° and 255°, preferably approximately 239°, and/or the fourth arc (80) describes an angle between 95° and 125°, preferably approximately 111°, and/or the radius of the third circle (E) is greater than the radius of the fourth circle (F), wherein the radius of the third circle (E) is preferably greater than the radius of the fourth circle (F) by 80% to 100%, particularly approximately 90%, and/or the outwardly disposed magnet series comprises two straight segments (79) connecting the free ends of the third and fourth arcs (78, 80).

10. Device according to one of claims 8 and 9, **characterised by** a third group (72) of magnets, which is arranged on the yoke plate (50) and forms an unclosed magnet series opposite the fourth arc (80) and which lies outside the first and second closed magnet series, wherein the third group (72) of magnets is preferably poled in the same direction as the second group (71) of magnets, and/or the third group (72) of magnets describes a fifth arc (81) of a fifth circle (H) with an angle of 15° to 45°, particularly approximately 32°, wherein the fifth circle (H) preferably has a greater radius than the third circle (E), and/or the third group (72) of magnets lies within the fourth circle (F).

11. Device according to any one of claims 8 to 10, **characterised in that** the centre points of the circles lie on a common straight line, and/or the magnet series are in mirror symmetry to the straight line, and/or the yoke plate (50) is flat and arranged rotationally symmetrically about a centre point (X), and/or a centre point (X) of the yoke plate and the centre points (B, D, G) of the circles (A, C, E, F, H) lie on a common straight line (Y),
wherein the common centre point (B) of the first and third circles (A, E) is preferably offset along the straight line (Y) with respect to the centre point (X) of the yoke plate, wherein the centre points (D, G) of the second and fourth circles (C, F) are preferably offset along the straight line (Y) with respect to the centre point of the yoke plate and preferably lie with respect to the centre point (X) of the yoke plate on a different side from the common centre point (B) of the first and third circles (A, E), wherein the common centre point (B) of the first and third circles (A, E) is preferably arranged at a spacing from the centre point (X) of the yoke plate which is smaller than a spacing between the centre point (X) of the yoke plate and the centre point. (D) of the second circle (C), and the centre point (G) of the fourth circle (F) is preferably arranged at a greater spacing from the centre point (X) of the yoke plate (50) than the centre point (D) of the circle (C), and/or the magnets (54) are guided by at least one non-magnetic plate (52) with a corresponding passage openings for the magnets (54), and/or that non-magnetic compensating weights (56) for compensation for the weight of the magnet system (7) are so provided at the yoke plate (50) that the centre of gravity thereof lies on a normal extending through a centre point (X) of the yoke plate (50).

## Revendications

1. Procédé pour appliquer un revêtement sur des substrats, dans lequel le substrat est revêtu par un processus à magnétron avec une cible devant être pulvérisée et un système magnétique tournant, **caractérisé en ce qu'**un état de pulvérisation de la cible est déterminé et que la vitesse de rotation du système magnétique est commandée en fonction de l'état de pulvérisation déterminé pour la cible.

2. Procédé selon la revendication 1, **caractérisé en ce que** l'état de pulvérisation de la cible est déterminé d'après la durée de vie restante et/ou d'après le nombre de processus de pulvérisation exécutés.

3. Procédé selon l'une quelconque des revendications précédentes, **caractérisé en ce que** la vitesse de rotation du système magnétique est diminuée à pulvérisation croissante de la cible.

4. Procédé selon l'une quelconque des revendications précédentes, **caractérisé en ce qu'**un support de données optique est revêtu d'une couche réfléchissante, la couche réfléchissante étant formée de préférence en une couche d'aluminium ou d'argent ou d'alliages de ces derniers.

5. Procédé selon l'une quelconque des revendications précédentes, **caractérisé en ce que** la vitesse de rotation du système magnétique est aussi choisie en fonction du matériau de cible utilisé.

6. Procédé selon l'une quelconque des revendications précédentes, **caractérisé en ce que** d'après la consommation d'énergie d'un moteur, il est déterminé si une cible se trouve dans le dispositif de pulvérisation et/ou si le système magnétique tourne de façon conforme. '

7. Dispositif pour le revêtement de substrats qui comporte une cathode de pulvérisation avec une cible et un système magnétique tournant, **caractérisé en ce que** des moyens sont prévus pour la détermination d'un état de pulvérisation de la cible ainsi que pour la commande d'une vitesse de rotation du système magnétique en fonction de l'état de pulvérisation déterminé.

8. Dispositif selon la revendication 7, **caractérisé en ce que** le système magnétique comporte les éléments suivants: un plateau culasse (50) et au moins un premier groupe (70) et un deuxième groupe (71) d'aimants qui sont disposés sur le plateau culasse (50) avec des polarités opposées, les aimants du premier groupe (70) formant une rangée d'aimants sensiblement fermée disposée à l'intérieur et les aimants du deuxième groupe (71) formant une rangée d'aimants sensiblement fermée disposée à l'extérieur, qui entoure radialement la rangée d'aimants disposée à l'intérieur, la rangée d'aimants disposée à l'intérieur formant un premier arc de cercle (75) qui décrit un angle, supérieur à 180°, d'un premier cercle (A), ainsi qu'un deuxième arc de cercle (76) d'un deuxième cercle (C), sachant que le deuxième arc de cercle (76) se trouve à l'intérieur du premier cercle (A) et sachant que la rangée d'aimants se trouvant à l'extérieur forme un troisième arc de cercle (78) qui décrit un angle de plus de 180° d'un troisième cercle (E), ainsi qu'un quatrième arc de cercle (80) d'un quatrième cercle (F), sachant que le quatrième arc de cercle (80) se trouve à l'intérieur du troisième cercle (E), et que le troisième cercle (E) entoure le premier cercle (A), sachant que le premier et le troisième cercle (A, E) présentent de préférence un centre (B) commun.

9. Dispositif selon la revendication 8, **caractérisé en ce que** le premier arc de cercle (75) décrit un angle compris entre 220° et 250°, et de préférence d'environ 235°, et/ou **en ce que** le deuxième arc de cercle (76) décrit un angle compris entre 90° et 120°, et de préférence d'environ 103°, et/ou **en ce que** le premier et le deuxième cercle (A, C) de la rangée d'aimants se trouvant à l'intérieur présentent sensiblement le même rayon, et/ou **en ce que** le troisième arc de cercle (78) décrit un angle compris entre 225° et 255°, et de préférence d'environ 239°, et/ou **en ce que** le quatrième arc de cercle (80) décrit un angle compris entre 95° et 125°, et de préférence d'environ 111°, et/ou **en ce que** le rayon du troisième cercle (E) est plus grand que le rayon du quatrième cercle (F), sachant que le rayon du troisième cercle (E) est de préférence de 80 % à 100 %, en particulier d'environ 90 % plus grand que le rayon du quatrième cercle (F), et/ou que la rangée d'aimants se trouvant à l'extérieur comporte deux segments droits (79) qui relient les extrémités libres des troisième et quatrième arcs de cercle (78, 80)

10. Dispositif selon l'une quelconque des revendications 8 ou 9, **caractérisé par** un troisième groupe (72) d'aimants qui est disposé sur le plateau culasse (50), qui forme une rangée d'aimants non fermée se trouvant en face du quatrième arc de cercle (80) et qui se trouve à l'extérieur des première et deuxième rangées d'aimants fermées, sachant que le troisième groupe (72) d'aimants est polarisé de préférence dans le même sens que le deuxième groupe (71) d'aimants, et/ou que le troisième groupe (72) d'aimants décrit un cinquième arc de cercle (81) d'un cinquième cercle (H), avec un angle de 15° à 45° et en particulier d'environ 32°, sachant que le cinquième cercle (H) possède de préférence un rayon plus grand que le troisième cercle (E) et/ou que le troisième groupe (72) d'aimants se trouve à l'intérieur du quatrième cercle (F).

11. Dispositif selon l'une quelconque des revendications 8 à 10, **caractérisé en ce que** les centres des cercles se trouvent sur une droite commune et/ou **en ce que** les rangées d'aimants sont symétriques par rapport à un plan par rapport à la droite et/ou **en ce que** le plateau culasse (50) est plan et a une symétrie de rotation autour d'un centre (X) et/ou **en ce qu'**un centre (X) du plateau culasse et les centres (B, D, G) des cercles (A, C, E, F, H) se trouvent sur une droite commune (Y), sachant que le centre (B) commun du premier et du troisième cercle (A, E) est décalé en direction du centre (X) du plateau culasse, de préférence le long de la droite (Y), sachant que les centres (D, G) du deuxième et du quatrième cercle (C, F) sont décalés en direction du centre du plateau culasse, de préférence le long de la droite (Y), et se trouvent de préférence par rapport au centre (X) du plateau culasse d'un autre côté que le centre (B) commun du premier et du troisième cercle (A, E), sachant que le centre (B) commun du premier et du troisième cercle (A, E) est disposé de préférence à une distance du centre (X) du plateau culasse qui est plus petite que la distance entre le centre (X) du plateau culasse et le centre (D) du deuxième cercle (C), et que le centre (G) du quatrième cercle (F) est disposé de préférence à une distance du centre (X) du plateau culasse (50) plus grande que le centre (D) du cercle (C) et/ou que les aimants (54) sont conduits à travers au moins une plaque (52) amagnétique avec des ouvertures de passage appropriées pour les aimants (54), et/ou que des masses d'équilibrage (56) amagnétiques sont prévues de telle sorte sur le plateau culasse (50) pour la compensation du poids du système magnétique (7) que leur centre de gravité se trouve sur une normale passant par un centre (X) du plateau culasse (50).
